# EUROPEAN PATENT APPLICATION

(11) **EP 1 653 493 A1**
(43) Date of publication of application: **03.05.2006**
(21) Application number: 04722952.1
(22) Date of filing: 24.03.2004
(51) Int. Cl.: H01H 35/00, H01H 21/00

(54) **VARIABLE HAND SWITCH**

(30) Priority: 26.03.2003 JP 2003084376
(71) Applicant: Takachi, Ken, Nishinomiya-shi, Hyogo 662-0014 (JP)
(72) Inventor: Takachi, Ken, Nishinomiya-shi, Hyogo 662-0014 (JP)
(74) Representative: Oser, Andreas
(86) International application number: PCT/JP2004/004095
(87) International publication number: WO 2004/086438

(57) **Abstract**

The variable hand switch has a switch body (40) formed of a resin molded body for providing elasticity, and the switch body (40) includes a base portion (41), a first pressing area member (42) formed at a tip end of the base portion (41) and bent upward in a U-shape from the base portion (41), and a first hanging wall (43) as a movable wall extending from the first pressing area member (42) toward the side of the base portion (41) (to the pressing direction). Opposite to one surface of the first hanging wall (43), an optical cable (30A) is fixedly arranged. This arrangement provides a variable hand switch having a structure capable of transmitting accurate control information to the body of an apparatus.

## Description

### Technical Field

The present invention relates to a variable hand switch and, more specifically, to a structure of an explosion-proof variable hand switch.

### Background Art

When an apparatus is operated at a factory or the like handling a flammable gas, generation of a spark possibly leads to a serious accident. Therefore, an explosion-proof switch that prevents generation of a spark is used as switches for operating apparatuses. Further, an explosion-proof variable hand switch has been employed, which enables operation of an apparatus at a place away from the apparatus itself, with the switch alone being held by one's hand.

In an example of the explosion-proof variable hand switch, in order to prevent generation of a spark, metal contact is avoided and operation is controlled by using air pressure. For instance, such a control is possible that, when the air pressure is high, speed of operation of an apparatus is made higher, and when the air pressure is low, speed of operation of the apparatus is made lower.

The conventional art related to the present invention has been described based on general technical information known to the applicant. To the best of applicant's memory, the applicant does not have any information to be disclosed as prior art, before the filing of this application, and the applicant is not aware of any other earlier patent application filed by the applicant.

The variable hand switch utilizing the high/low level of air pressure described above is problematic, as an accurate air pressure is not transmitted to the apparatus itself and accurate control of the apparatus itself is difficult, because of bending or expansion of an air cable, ambient temperature and the like. Similar problems have also been pointed out not only at factories and the like handling flammable gases but also in the medical field.

### Disclosure of the Invention

The present invention was made to solve the above-described problems, and its object is to provide an explosion-proof variable hand switch having a structure that can transmit accurate control to the body of the apparatus.

In order to attain the above-described object, according to an aspect, the present invention provides a variable hand switch controlling an amount of light emitted from light projecting means, receiving the light with the amount changed, by light receiving means, and transmitting information of the received light to a body of an apparatus, including: a wall arranged opposite to the light projecting means and the light receiving means; and a light amount changing area provided on the wall for changing the amount of light projected from the light projecting means, in accordance with relative movement between the wall and the light projecting means and the light receiving means.

As described above, an arrangement using light projecting means, in which the amount of light on a light amount changing area is read by photo means in a non-contact manner is employed, so that explosion-proof is attained as metal contact is eliminated, and in addition, the amount of light from the light amount changing area can be adjusted by controlling relative amount of movement between the light projecting means, light receiving means and the movable wall. Accordingly, accurate control information corresponding to the amount of control can be transmitted to the body of the apparatus, without any influence of disturbance.

Further, according to another aspect, the present invention provides a variable hand switch controlling reflectance of light emitted from light projecting and receiving means and transmitting change in reflectance to a body of an apparatus, including: a movable wall provided continuously movable between a first position and a second position, and arranged opposite to the light projecting and receiving means; and a light reflecting area provided on a surface of the movable wall facing the light projecting and receiving means having at least two areas providing different reflectance of light projected from the light projecting and receiving means, along with movement of the movable wall.

As described above, an arrangement using light projecting and receiving means, in which amount of reflected light at the reflection area is read in non-contact manner is employed, so that explosion-proof is attained as metal contact is eliminated, and in addition, the amount of reflected light at the reflection area can be controlled by controlling the amount of movement of the movable wall. Accordingly, accurate control information corresponding to the amount of control can be transmitted to the body of the apparatus, without any influence of disturbance.

In a preferable implementation of the invention, the reflecting area has a colored area with gradation, in which color tone changes gradually along the direction of movement of the movable wall. Consequently, the amount of reflected light at the reflection area can be controlled continuously, and therefore, continuous control of the body of the apparatus, such as speed control and feed control becomes possible.

Further, in a preferable implementation of the invention, the reflecting area includes a first colored area and a second colored area having darker colored area than the first colored area, arranged along the direction of movement of the movable wall. This enables control based on binary determination, and therefore, ON/OFF control, for example, becomes possible.

According to a still further aspect, the present invention provides a variable hand switch controlling an amount of light emitted from light projecting means, receiving the light with the amount changed, by light receiving means, and transmitting information of the received light to a body of an apparatus, including: a movable wall provided continuously movable between a first position and a second position, and arranged between and opposite to the light projecting means and the light receiving means; and a light transmittance changing area for changing amount of transmittance of light projected from the light projecting means along with the movement of the movable wall.

As described above, an arrangement using light projecting and receiving means, in which amount of light transmitted through a light transmittance changing area is read in a non-contact manner is employed, so that explosion-proof is attained as metal contact is eliminated, and in addition, the amount of light transmitted through the light transmittance changing area can be controlled by controlling the amount of movement of the movable wall. Accordingly, accurate control information corresponding to the amount of control can be transmitted to the body of the apparatus, without any influence of disturbance.

Further, in a preferable implementation of the invention, the light transmittance changing area has a colored area with gradation, in which color tone changes gradually along the direction of movement of the movable wall. This enables continuous control of the amount of light transmitted through the light transmittance changing area, and therefore, continuous control of the body of the apparatus, such as speed control and feed control becomes possible.

Further, in a preferable implementation of the invention, the light transmittance changing area includes a first colored area and a second colored area having darker colored area than the first colored area, arranged along the direction of movement of the movable wall. This enables control based on binary determination, and therefore, ON/OFF control, for example, becomes possible.

Further, in a preferable implementation of the invention, the movable wall is formed of a hanging wall extended, from a pressing area member positioned on a surface side of the variable hand switch, in the direction of pressing; and the first position of the movable wall is selected when the pressing area member is not pressed, and the second position of the movable wall is selected by gradually pressing the pressing area member. Therefore, by holding the variable hand switch with one hand and operating the same with the thumb of the holding hand, the variable hand switch can be operated reliably with one hand.

Further, in a preferable implementation of the invention, the pressing area member has means for applying elastic force for applying an elastic force acting in a direction opposite to the direction of pressing, when the pressing area member is pressed in the pressing direction. Therefore, when the force of pressing is decreased, the pressing area member automatically returns to the original state, and thus, operability can further be improved.

### Brief Description of the Drawings

Fig. 1 is an entire exploded perspective view showing overall structure and inner structure of the variable hand switch in accordance with a first embodiment.
Fig. 2 shows the variable hand switch in accordance with the first embodiment held by a hand.
Fig. 3 is a schematic illustration representing a principle of controlling movement of a movable wall in the variable hand switch in accordance with the first embodiment.
Fig. 4 is a first schematic illustration showing a control operation of the variable hand switch in accordance with the first embodiment.
Fig. 5 is a second schematic illustration showing a control operation of the variable hand switch in accordance with the first embodiment.
Fig. 6 is a third schematic illustration showing a control operation of the variable hand switch in accordance with the first embodiment.
Fig. 7 shows another structure of a switch body in accordance with the first embodiment.
Fig. 8 shows an exemplary application of the variable hand switch in accordance with the first embodiment.
Fig. 9 is an overall perspective view showing an appearance of a variable hand switch in accordance with a second embodiment.
Fig. 10 is a first schematic illustration representing a principle of operation of the variable hand switch in accordance with the second embodiment.
Fig. 11 is a second schematic illustration representing a principle of operation of the variable hand switch in accordance with the second embodiment.
Fig. 12 is an enlarged partial cross section showing an internal structure of a variable hand switch in accordance with a third embodiment.
Fig. 13 is a cross section taken along the line XIII-XIIT of Fig. 12.
Fig. 14 is a partial perspective view showing another internal structure of the variable hand switch in accordance with the third embodiment.

### Best Modes for Carrying Out the Invention

In the following, variable hand switches in accordance with various embodiments based on the present invention will be described with reference to the figures.

### (First Embodiment)

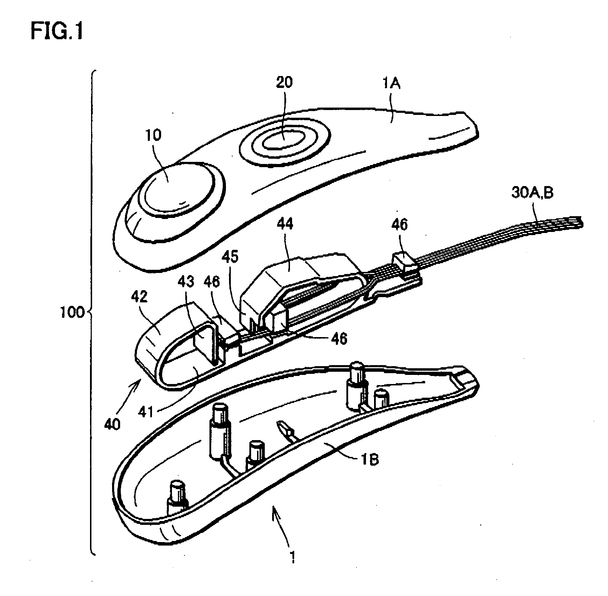

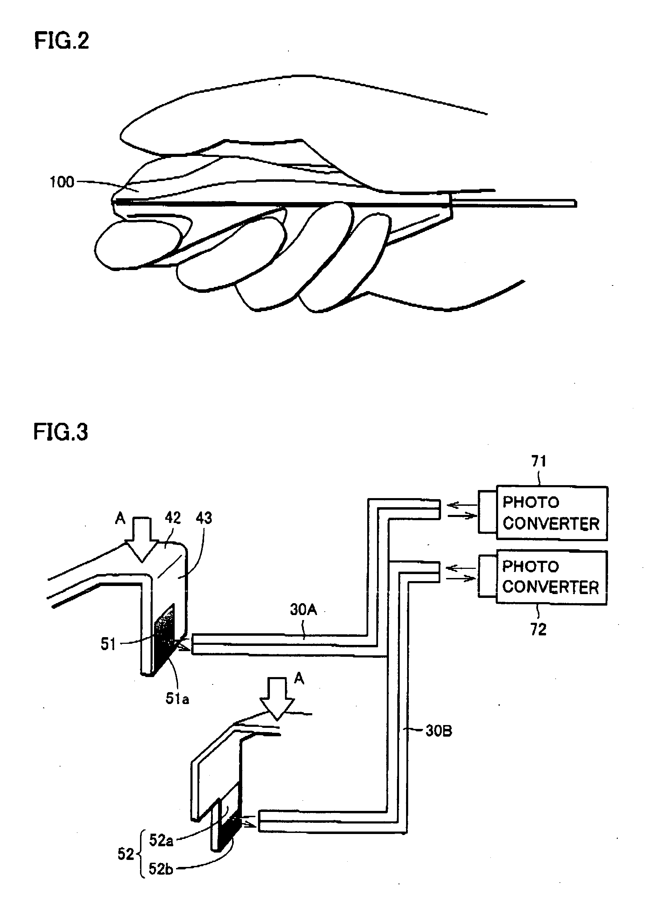

First, referring to Figs. 1 and 2, an appearance of a variable hand switch in accordance with the first embodiment will be described. Fig. 1 is an entire exploded perspective view showing overall structure and inner structure of the variable hand switch 100, and Fig.2 shows variable hand switch 100 held by one hand.

### (Appearance of variable hand switch 100)

Variable hand switch 100 is intended to be held by a hand, and therefore, it has a longitudinal housing case 1 having a curved shape fit for good holding. Housing case 1 has a structure divided into two, including a first case 1A and a second case 1B. Between the first and second cases 1A and 1B, an area allowing attachment/detachment of these cases is provided.

On an upper surface of first cast 1A, a first switch 10 having an approximately curved shape formed of an elastic member (silicone rubber or the like) serving as a switch, and a second switch 20 having an approximately curved shape formed of an elastic member (silicone rubber or the like) also serving as a switch are provided. Though the first and second switches 10 and 20 may have the same shape, they should preferably have different shapes, in order to distinguish switch types from each other.

### (Appearance of switch body 40)

Between the first and second cases 1A and 1B, a switch body 40 formed of a resin-molded body controlled by the first and second switches 10 and 20 is placed. Switch body 40 includes: a base portion 41; a first pressing area member 42 formed bent upward in a U-shape from base portion 41 at a tip end of base portion 41; and a first hanging wall 43 as a movable wall, extending from the first pressing area member 42 toward the base portion 41 (to the direction of pressing). The U-shaped configuration is to provide elastic force.

On the rear end of base portion 41, a second pressing area member 44 formed bent upward in a U-shape from base portion 41, and a second hanging wall 45 as a movable wall extending from the second pressing area member 44 toward the base portion 41 (to the direction of pressing) are provided.

Fixing support members 46 are provided on base portion 41 between the first and second hanging walls 43 and 45, below the second pressing area member 44 and at the rearmost end of base portion 41, for fixing an optical cable, which will be described later.

### (Control operation)

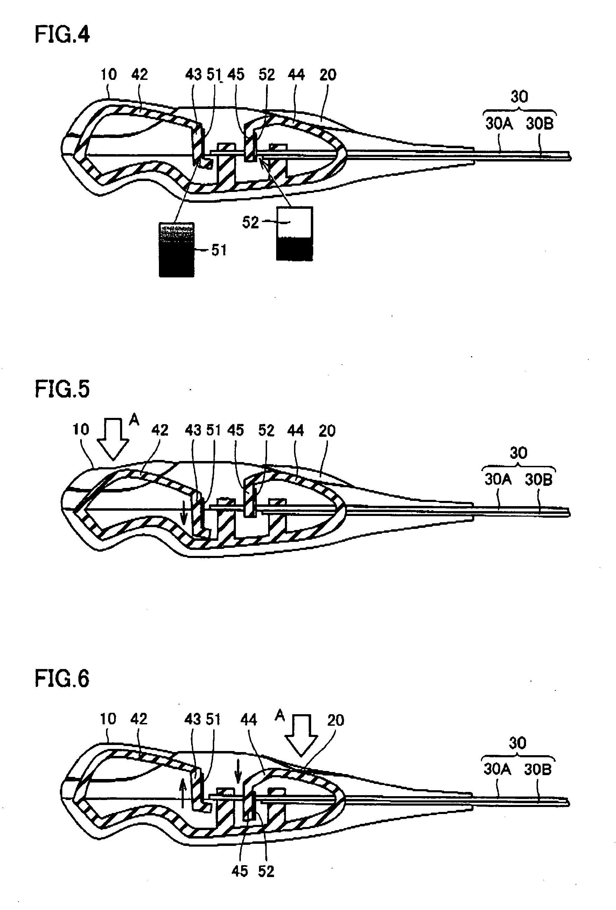

Next, the control operation of variable hand switch 100 having such a structure as above will be described with reference to Figs. 3 to 6. Fig. 3 is a schematic illustration representing the principle of control in moving the first and second hanging walls 43 and 45 as movable walls, and Figs. 4 to 6 are first to third illustrations representing the control operation.

First, referring to Fig. 3, an optical cable 30A as light projecting and receiving means is fixedly arranged opposite to one surface of first hanging wall 43. On the apparatus side of optical cable 30A, a photo converter 71 is provided. Further, on a surface facing optical cable 30A of the first hanging wall 43, a gradation sheet 51 as a colored area 51a having its color tone changed gradually along the direction of movement of first hanging wall 43 is adhered. In the present embodiment, gradation sheet 51 of which color changes from white to black (no-reaction area) is adopted.

When the first hanging wall 43 moves in the direction A while light is being emitted from optical cable 30A, the amount of light to optical cable 30A can be changed continuously, as the reflectance of light reflected from gradation sheet 51 changes. The change in the amount of light can be read by photo converter 71.

Similarly, an optical cable 30B as light projecting and receiving means is fixedly arranged opposite to one surface of second hanging wall 45. On the apparatus side of optical cable 30B, a photo converter 72 is provided. Further, on a surface facing optical cable 30B of the second hanging wall 45, a colored area sheet 52 is adhered, which has a first colored area 52a and a second colored area 52b having a darker color than the first colored area 52a, arranged along the direction of movement of second hanging wall 45. In the present embodiment, the first colored area 52a of white and the second colored area (no-reaction area) 52b of black are adopted.

When the second hanging wall 45 moves in the direction A while light is being emitted from optical cable 30B, the amount of light to optical cable 30B can be changed in binary manner, as the reflectance of light reflected from gradation sheet 51 changes. The change in the amount of light can be read by photo converter 72.

Next, referring to Figs. 4 to 6, the control operation of variable hand switch 100 will be described. Fig. 4 shows a state in which no external force is exerted on the first and second switches 10 and 20. Therefore, no external force is applied to the first and second hanging walls 43 and 45, either (first position). At this time, optical cable 30A is opposite to the "darkest" position (no-reaction area) of gradation sheet 51, and optical cable 30B is opposite to the position of the second color area (no-reaction area) 52b of "black".

Next, referring to Fig. 5, the state in which the first switch 10 is pressed by a finger will be described. When the first switch 10 is pressed in the direction A, the first pressing area member 42 is pressed downward by the first switch 10. As a result, the first hanging wall 43 moves downward. The deepest pressed position is the second position. At the second position, optical cable 30A is opposite to the "brightest" position of gradation sheet 51. Thus, the amount of light to optical cable 30A can be changed continuously, and continuous control of the apparatus body becomes possible. Referring to Fig. 6, by canceling or weakening the force pressing the first switch 10, the first pressing area member 42 recovers because of the elasticity of the first pressing area member 42 itself, and the first hanging wall 43 can easily be returned to the first position.

Referring to Fig. 6, the state in which the second switch 20 is pressed by a finger will be described. When the second switch 20 is pressed in the direction A, the second pressing area member 44 is pressed downward by the second switch 20. As a result, the second hanging wall 45 moves downward. The deepest pressed position is the second position. At the second position, optical cable 30B is opposite to the first color area 52a of "white", of colored area sheet 52. Therefore, the amount of light to optical cable 30B can be changed in binary manner, and ON/OFF control of the apparatus body becomes possible. Further, referring to Fig. 5, by canceling or weakening the force pressing the second switch 20, the second pressing area member 44 recovers in accordance with the elasticity of the second pressing area member 44 itself, and the second hanging wall 45 can easily be returned to the first position.

### (Function/Effect)

As described above, in the variable hand switch 10 in accordance with the present embodiment, an arrangement in which the change in the amount of reflected light from gradation sheet 51 and colored area sheet 52 is read by using optical cables 30A and 30B is employed, whereby explosion-proof is attained as metal contact is eliminated. Further, as the amount of moving the first and second hanging walls 43 and 45 is controlled by the first and second switches 10 and 20, the amount of light reflected from gradation sheet 51 and colored area sheet 52 can be controlled. Therefore, accurate control information corresponding to the amount of control can be transmitted to the body of the apparatus, without any influence of disturbance.

Further, the apparatus body may be controlled such that the apparatus attains to the "OFF" state when the first and second hanging walls 43 and 44 are at the first position, whereby control working on the safer side can be realized.

Further, at the first position of the first and second hanging walls 43 and 44, the "darkest" position of gradation sheet 51 and the position of the second color area 52b of "black" are selected (no-reaction area), and therefore, even when optical cable 30A or 30B is bent and the light is intercepted, control on the safer side can be realized.

In order to adjust the force pressing the first hanging wall 43, an arrangement may be adopted in which a coil spring 60 as an elastic member is interposed between base 41 and the first pressing area member 42.

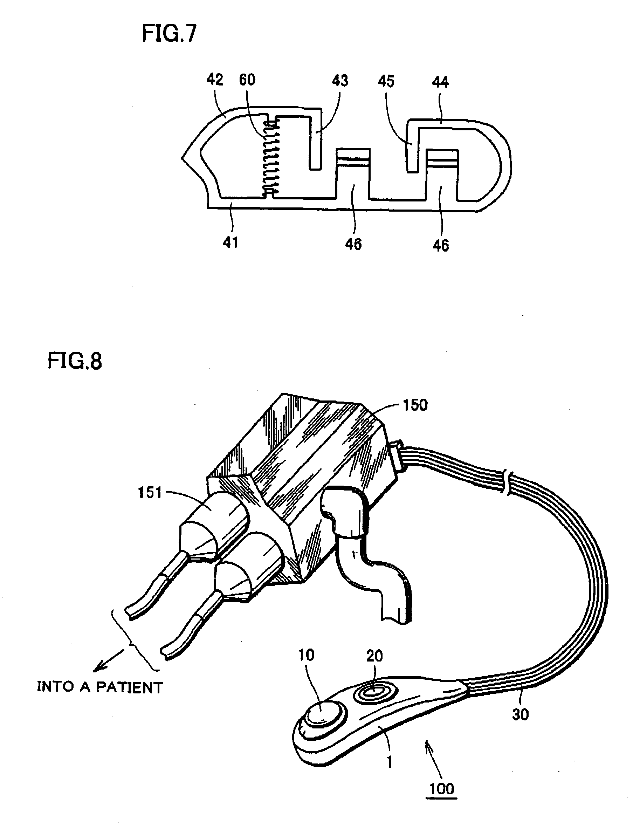

The explosion-proof variable hand switch 100 described above may be effectively used in a factory or the like handling a flammable gas, and it may also be used in the medical field. By way of example, variable hand switch 100 may be applied to control amount of injection of an injector head 150 for injecting a contrast medium in a syringe 151 into a patient, for angiography, as shown in Fig. 8.

### (Second Embodiment)

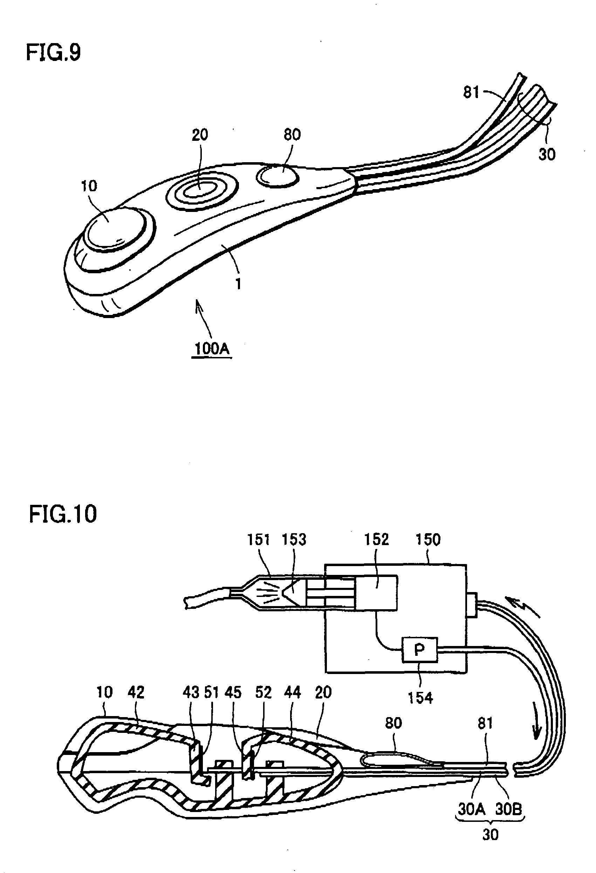

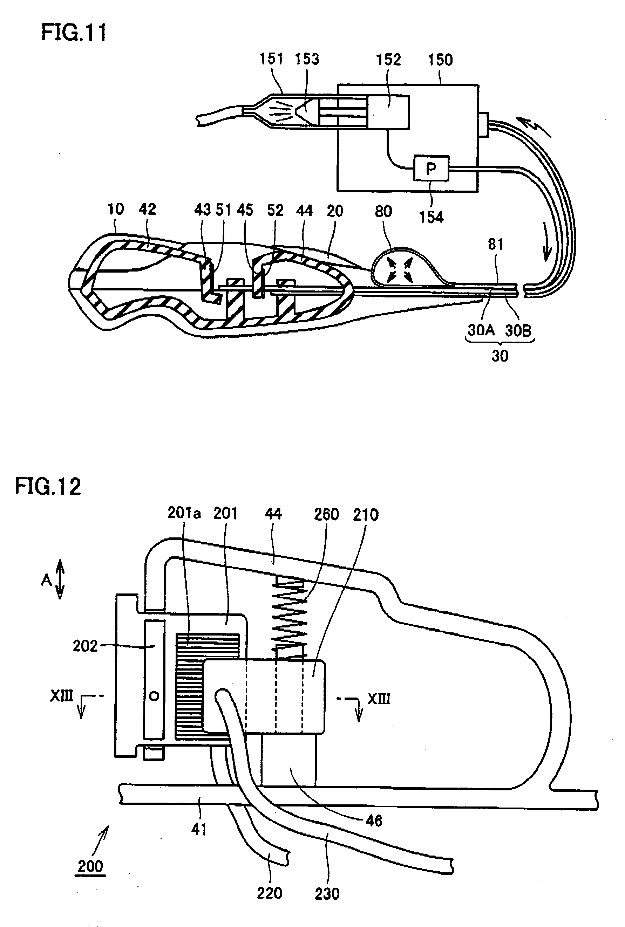

A second embodiment of variable hand switch 100A will be described with reference to Figs. 9 to 11. Fig. 9 is an overall perspective view showing an appearance of variable hand switch 100 in accordance with the present invention, and Figs. 10 and 11 are first and second schematic illustrations representing the principle of operation of variable hand switch 100A in accordance with the present embodiment.

By way of example, assume that variable hand switch 100A is applied for controlling the amount of introducing contrast medium of an injector head. An operator may wish to know the injection pressure of the contrast medium or the like to the patient. In such a case, an arrangement of variable hand switch 100A with an air bag 80 may be used.

Referring to Fig. 10, the injection pressure of the contrast medium to a patient is detected by an injection pressure measuring apparatus 152, through a plunger 153 in a syringe 151. Therefore, based on the information detected by injection pressure measuring apparatus 152, an air pump 154 is operated, and air is introduced to air bag 80 through an air tube 81. Accordingly, when the injection pressure of the contrast medium or the like to the patient becomes high, air bag 80 expands as shown in Fig. 11, and thus, increase in the injection pressure can be transmitted to the operator holding variable hand switch 100, thorough touch feeling. As a result, the operator can instantly adjust the pressing force of the switch, and hence, the contrast medium can bc injected at an appropriate pressure. The position where air bag 80 is provided may be appropriately selected, and air bag 80 may be provided to entirely cover housing case 1.

### (Third Embodiment)

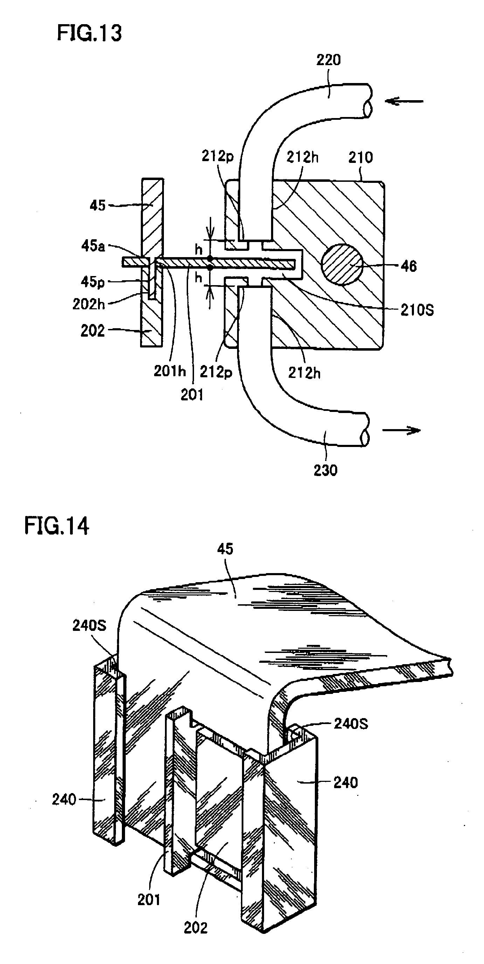

Next, a variable hand switch 200 in accordance with the third embodiment will be described with reference to Figs. 12 to 14. Fig. 12 is an enlarged partial cross section showing an internal structure of variable hand switch 200, Fig. 13 is a cross section taken along the line XIII-XIII of Fig. 12, and Fig. 14 is a partial perspective view representing another internal structure of variable hand switch of the present embodiment. It is noted that the basic structure of variable hand switch 200 in accordance with the present embodiment is the same as the structure of the first and second embodiments, and therefore, the same or corresponding portions are denoted by the same reference characters and description thereof will not be repeated. Only the characteristic structural portions will be described in detail in the following.

In variable hand switches 100 and 100A shown in the first and second embodiments, the amount of control is adjusted by measuring light reflectance as the change in the amount of light, using a gradation sheet or the like. In variable hand switch 200 in accordance with the present embodiment, light transmittance is measured as the change in the amount of light, for adjusting the amount of control.

Referring to Figs. 12 and 13, on the second hanging wall 45 of second switch 20, a control film 201 is attached, which extends along the direction of movement (direction A in the figure) of second hanging wall 45 and forming a wall erected substantially in the vertical direction with respect to the second hanging wall 45. Control film 201 has a fixing hole 201h formed at a base end portion, in a recessed portion 45 of second hanging wall 45, a pin 45p is inserted through fixing hole 201h, and by a block 202 having a fixing hole 202h receiving pin 45p, the film is pinched by second hanging wall 45. By setting the position of pin 45p off from the center, control film 201 can be attached without upside-down error. Control film 201 has a light transmittance changing area 201 a having a prescribed pattern, as an area at which the amount of light is changed.

Control film 201 must be erected, the prescribed light transmittance changing area 201 a must be provided thereon, and light transmittance must be controlled with high accuracy. Therefore, use of an art work film such as used for photoengraving is preferred, and the pattern provided on light transmittance changing area 201 a is also formed preferably by applying the photoengraving technique. As for the specific example of the pattern provided in light transmittance changing area 201a, a transmitting area having the gradation pattern or a pattern of two colored areas such as shown in Fig. 3 may be used.

As shown in Fig. 13, an optical cable fixing block 210 having a slit 210S pinching control film 201 from both sides is fixed on fixing support member 46, and between fixing support member 46 and second pressing area member 44, a coil spring 260 is mounted for applying elastic force to second pressing area member 44.

In the present embodiment, a light projecting side optical cable 220 as the light projecting means, and a light receiving side optical cable 230 as the light receiving means are provided, and in an optical cable fixing block 210, optical cable fixing holes 212h, 212h are provided for positioning and fixing the light projecting side optical cable 220 and light receiving side optical cable 230 such that control film 201 is opposite to the optical cables. As in the embodiments described above, photo converters are connected to light projecting side optical cable 220 and light receiving side optical cable 230, respectively.

Optical cable fixing holes 212h, 212h have a step portion 212p to which tip ends of light projecting side optical cable 220 and light receiving side optical cable 230 abut, so that when light projecting side optical cable 220 and light receiving side optical cable 230 are inserted to optical cable fixing holes 212h, 212h, light projecting side optical cable 220 and light receiving side optical cable 230 can easily be positioned and fixed.

Further, as shown in Fig. 14, in order to regulate the direction of movement of second hanging wall 45, a pair of guide slot walls 240, 240 having guide slots 240S slidably guiding opposite ends of the second hanging wall 45 may be provided on both sides of second hanging wall 45.

The control operation of variable hand switch 200 having such a structure is the same as that of the embodiments above, and when control film 201 moves downward while light is being emitted from light projecting side optical cable 220, the amount of light transmitted through light transmittance changing area 201a changes, and therefore, the amount of light to the light receiving side optical cable 230 can be changed continuously. The change in the amount o flight can be read by a photo converter 73 (see Fig. 3).

Though the arrangement of second switch 20 has been described above, similar arrangement is also applicable to the first switch 10.

### (Function/Effect)

As described above, in variable hand switch 200 of the present embodiment, an arrangement using light projecting side optical cable 220 and light receiving side optical cable 230, in which amount of light transmitted through light transmittance changing area 201a (gradation sheet 51, colored area sheet 52 or the like) is read in a non-contact manner is employed, so that explosion-proof is attained as metal contact is eliminated. In addition, transmittance of light transmitted through a light transmittance changing area 201a can be controlled by controlling the amount of movement of the first and second hanging walls 43 and 45 using the first and second switches 10 and 20. Accordingly, accurate control information corresponding to the amount of control can be transmitted to the body of the apparatus, without any influence of disturbance.

Further, the position of slit 210S for control film 201 can be fixed accurately, and therefore, even when control film 201 moves in the direction of the arrow A in the figure (see Fig. 12), the gap (h) between control film 201 and tip end of light projecting side optical cable 220 and light receiving side optical cable 230 can be kept constant. Accordingly, generation of signal error associated with movement of control film 201 can be prevented. In an arrangement that measures the change in light transmittance, the influence of diffuse reflection can be reduced on the light receiving side, which further prevents generation of signal error.

It is often the case that red light is emitted from light projecting side optical cable 220, and therefore, a color pattern having colors changed from one that transmits red light well to one that hardly transmits red light may be used as the pattern on light transmittance changing area 201a.

Though examples having two different types of switches have been described with respect to variable hand switches 100, 100A and 200 above, provision of two different types of switches is not always necessary, and an arrangement having one or a plurality of types of switches may be adopted. Further, an arrangement having structures of various embodiments combined may be adopted.

Further, in variable hand switches 100, 100A and 200, an arrangement is employed in which the light projecting side and the light receiving side are fixed, and the hanging wall or the control film as the wall or movable wall having light amount changing area is moved. The arrangement, however, is not limited thereto, and an arrangement may be possible in which the hanging wall or control film is fixed and the light projecting side and the light receiving side are moved.

A method of adjusting the amount of light not using a gradation sheet, a control film or the like, but moving only one fiber may be adopted. Specifically, an arrangement in which optical axes of two fibers are off from each other when the switch is not pressed and the axes gradually come closer to be aligned as the switch is being pressed, or an arrangement in which the distance between two fibers is changed, may be adopted. However, in order to correctly read the change in the amount of light and to enable highly accurate control by the variable hand switch, use of a gradation sheet or a control film for changing the amount of light as described in the embodiments above is preferable.

The embodiments as have been described here are mere examples and should not be interpreted as restrictive. The scope of the present invention is determined by each of the claims with appropriate consideration of the written description of the embodiments and embraces modifications within the meaning of, and equivalent to, the languages in the claims.

### (Effects of the Invention)

The variable hand switch based on the present invention enables transmission of accurate control information corresponding to the amount of control to the body of an apparatus without any influence of disturbance.

## Claims

1. A variable hand switch (100A, 100B, 200) controlling an amount of light emitted from light projecting means, receiving the light with the amount changed, by light receiving means, and transmitting information of the received light to a body of an apparatus, comprising:
a wall (43, 45, 201) arranged opposite to said light projecting means (30A, 220) and said light receiving means (30B, 230); and
a light amount changing area (51, 52, 201 a) provided on said wall (43, 45, 201) for changing the amount of light projected from said light projecting means (30A, 220), in accordance with relative movement between said wall (43, 45, 201) and said light projecting means (30A, 220) and said light receiving means (30B, 230).

2. A variable hand switch (100A, 100B) controlling reflectance of light emitted from light projecting and receiving means (30A, 30B) and transmitting change in reflectance to a body of an apparatus, comprising:
a movable wall (43, 45) provided continuously movable between a first position and a second position, and arranged opposite to said light projecting and receiving means (30A, 30B); and
a light reflecting area (51, 52) provided on a surface of said movable wall (43, 45) facing said light projecting and receiving means (30A, 30B) having at least two areas providing different reflectance of light projected from said light projecting and receiving means (30A, 30B), along with movement of said movable wall (43, 45).

3. The variable hand switch according to claim 2, wherein
said reflecting area (51) has a colored area with gradation, in which color tone changes gradually along the direction of movement of said movable wall.

4. The variable hand switch according to claim 2, wherein
said reflecting area (52) includes a first colored area and a second colored area having darker colored area than the first colored area, arranged along the direction of movement of said movable wall.

5. The variable hand switch according to claim 2, wherein
said movable wall (43, 45) is formed of a hanging wall extended, from a pressing area member (42, 44) positioned on a surface side of said variable hand switch, in the direction of pressing; and
the first position of said movable wall (43, 45) is selected when said pressing area member (42, 44) is not pressed, and the second position of said movable wall (43, 45) is selected by gradually pressing said pressing area member (42, 44).

6. The variable hand switch according to claim 2, wherein
said pressing area member (42, 44) has means (60) for applying elastic force for applying an elastic force acting in a direction opposite to the direction of pressing, when said pressing area member (42, 44) is pressed in the pressing direction.

7. A variable hand switch (200) controlling an amount of light emitted from light projecting means, receiving the light with the amount changed, by light receiving means, and transmitting information of the received light to a body of an apparatus, comprising:
a movable wall (201) provided continuously movable between a first position and a second position, and arranged between and opposite to said light projecting means (220) and said light receiving means (230); and
a light transmittance changing area (201a) for changing amount of transmittance of light projected from said light projecting means (220) along with the movement of said movable wall (201).

8. The variable hand switch according to claim 7, wherein
said light transmittance changing area (201a) has a colored area with gradation, in which color tone changes gradually along the direction of movement of said movable wall.

9. The variable hand switch according to claim 7, wherein
said light transmittance changing area (201a) includes a first colored area and a second colored area having darker colored arca than the first colored area, arranged along the direction of movement of said movable wall.

10. The variable hand switch according to claim 7, wherein
said movable wall (201) is formed of a hanging wall extended, from a pressing area member (42, 44) positioned on a surface side of said variable hand switch, in the direction of pressing; and
the first position of said movable wall (201) is selected when said pressing area member (42, 44) is not pressed, and the second position of said movable wall (201) is selected by gradually pressing said pressing area member (42, 44).

11. The variable hand switch according to claim 7, wherein
said pressing area member (42, 44) has means (260) for applying elastic force for applying an elastic force acting in a direction opposite to the direction of pressing, when said pressing area member (42, 44) is pressed in the pressing direction.
